(19) Europäisches Patentamt
European Patent Office
Office européen des brevets

(11) Publication number: 0 319 296 A2

(12) EUROPEAN PATENT APPLICATION

(21) Application number: 88311391.2

(51) Int. Cl.4: G03C 1/68

(22) Date of filing: 01.12.88

(30) Priority: 04.12.87 GB 8728389

(43) Date of publication of application: 07.06.89 Bulletin 89/23

(84) Designated Contracting States: AT BE CH DE ES FR GB GR IT LI LU NL SE

(71) Applicant: COOKSON GROUP plc
14 Gresham Street
London EC2V 7AT(GB)

(72) Inventor: Coyle, John David
14 Highlands Close Chalfont St. Peter
Buckinghamshire, SL9 0DR(GB)
Inventor: Bradshaw, Colin
68 Jersey Road Milton Keynes
Buckinghamshire, MK12 5BH(GB)

(74) Representative: Allard, Susan Joyce et al
BOULT, WADE & TENNANT 27 Furnival Street
London EC4A 1PQ(GB)

# (54) Photopolymerisable composition.

(57) A photopolymerisable composition which comprises

(a) one or more ethylenically unsaturated polymerisable compounds
(b) at least one triazine compound of formula I, and

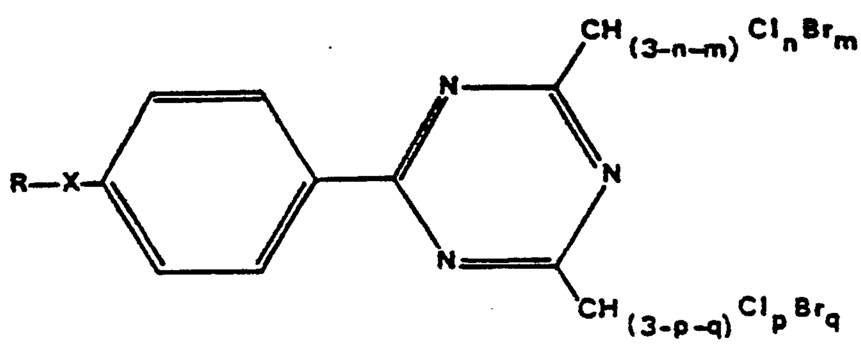

I

(c) at least one compound absorbing in the region 400-600 nm selected from

(i) dyes, other than azo dyes,
(ii) ketocoumarins,
(iii) 2-benzylideneindan-1,3-diones, and
(iv) pyrylium salts and thiapyrylium salts.

EP 0 319 296 A2

## PHOTOPOLYMERISABLE COMPOSITION

The invention relates to a photopolymerisable composition comprising ethylenically unsaturated polymerisable compounds, such as acrylates, of the kind used for preparing photosensitive printing plates.

Photosensitive printing plates may be formed by providing a layer of a photopolymerisable composition on a suitable anodised aluminium sheet. The composition is polymerised by radiation. The radiation may be provided by an ordinary UV light source such as a metal halide lamp or by a mercury lamp. One convenient source of visible radiation which is now often used is an argon ion laser which produces light of specific wavelengths within the range of 400-600nm. Known compositions employed in photosensitive printing plates contain polymerisable compounds such as acrylates together with a polymerisation initiator. Various compounds are known as initiators and these include trihalomethyl-substituted triazines such as those described in US 4330590, US 4189323, US 4258123, US 4481276 and European Patent Application No. 87309489.0. However, while such triazines are often responsive to ultraviolet light they are often not sufficiently sensitive to light in the range 400-600nm to produce a satisfactory image when exposed by an argon ion laser. It has also been proposed, for example in US 4481276 and US 4258123, to combine the triazine with further light-sensitive compounds in order to improve the sensitivity of the composition.

It has now been found that by employing a triazine in combination with one or more of certain sensitising compounds which absorb light in the range 400-600nm it is possible to prepare a photopolymerisable composition which has improved sensitivity to light in the range 400-600nm and which enables the production of photosensitive plates which may be satisfactorily exposed by light from an argon ion laser.

Thus, in accordance with the present invention there is provided a photopolymerisable composition comprising

(a) one or more ethylenically unsaturated polymerisable compounds, for example acrylates,

(b) at least one triazine compound of formula I

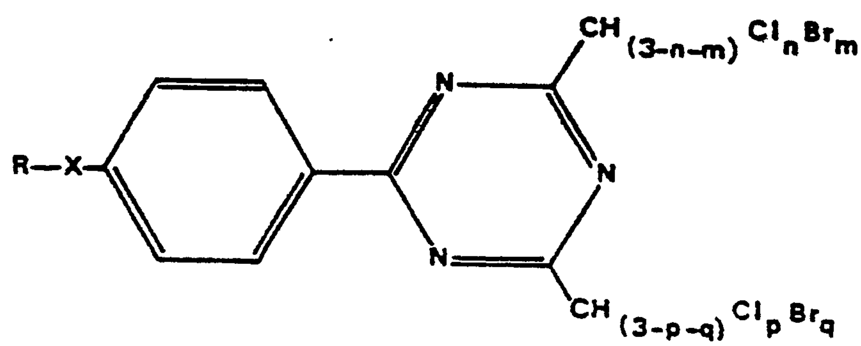

I

wherein n, m, p and q are each independently 0, 1, 2 or 3, the sum of n+m is not greater than 3, the sum of p+q is not greater than 3 and the sum of n+m+p+g is at least 1, X is a sulphur, selenium or tellurium atom and R is an alkyl group or an aryl group,

(c) at least one compound absorbing in the region 400-600nm selected from

(i) dyes, other than azo dyes,

(ii) ketocoumarins,

(iii) 2-benzylideneindan-1,3-diones of formula II

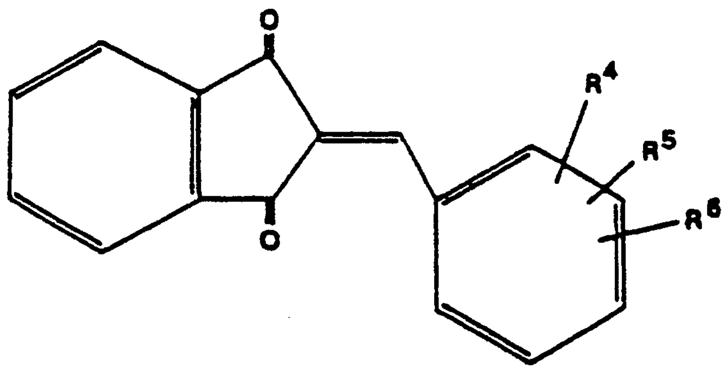

II

wherein $R^4$, $R^5$ and $R^6$ are each independently a hydrogen atom, an alkoxy group, a dialkylamino group or an alkyl group, and

(iv) pyrylium salts and thiapyrylium salts having a cation of formula III

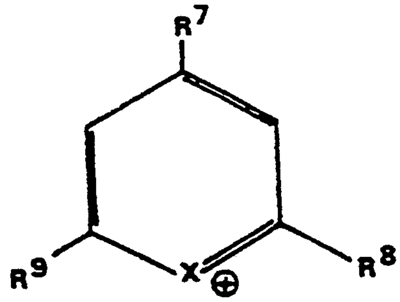

III

wherein X is oxygen or sulphur and $R^7$, $R^8$ and $R^9$ are each independently an aryl group.

The term "alkyl group" includes substituted and unsubstituted alkyl groups and references to "aryl", "alkenyl", "aralkyl", "alkoxy" and "dialkylamino" groups should be similarly construed.

Compositions containing the specified components (a), (b) and (c) have improved sensitivity to light in the range 400-600nm and can be effectively employed with, for example, light of wavelength 488nm from an argon ion laser.

Although the applicant does not wish to be bound by theory it is believed that component (b) and component (c) of the present invention act respectively as initiator and sensitiser for the polymerisation reaction. Thus, the sensitiser is thought to absorb incident radiation in the range 400-600nm and to transfer the resulting excitation energy to the triazine. The excited triazine then cleaves to give an organic radical and a halogen radical which initiate the polymerisation reaction. If used on its own in a photopolymerisable composition the triazine is not normally sufficiently sensitive to radiation in the range 400-600nm to initiate the polymerisation reaction.

Preferably the triazine will contain more than one carbon-halogen bond in order to increase the possibility of formation of radicals. Thus, preferably, the sum of $n+m$ and the sum of $p+q$ will each be 1, 2 or 3 and most preferably will each be 3.

Triazines may be prepared by the general method described in Bull. Chem. Soc. Japan, 1969, 42, pages 2924 to 2930, by cotrimerization of the halogenated acetonitrile with a substituted benzonitrile, in the presence of hydrochloric acid and a Friedel-Crafts catalyst, e.g. $AlCl_3$, $AlBr_3$, $TiCl_4$, or boron trifluoride etherate. Other ways of synthesizing triazines are by reacting aryl amidines with polychloroaza-alkenes according to the method published in Angew. Chem. 1966, 72, p. 982 et seq. Methods for the subsequent chlorination and bromination of alkyl substituents in s-triazines and exchange reaction in which bromine atoms in tribromomethyl groups may be replaced by hydrogen are disclosed in J. Org. Chem., 1969, 29, p. 1527 et. seq. Some of the nitriles used in the co-trimerization may be prepared by simple methods known in the art, for example by the dehydration of carboxylic acid amides or oximes, or by the reaction of aromatic bromine compounds with cuprous cyanide.

The particular triazines employed in the present invention are those described in our European Patent

Application No. 87309489.0, published as EP 0271195A.

Examples of triazines which may be employed as the component (b) in the present invention include 2-(4-methylthiophenyl)-4,6-bis(trichloromethyl)-1,3,5-triazine, 2-(4-ethylthiophenyl)-4,6-bis-(trichloromethyl)-1,3,5-triazine, 2-(4-stearylthiophenyl)-4,6-bis(trichloromethyl)-1,3,5-triazine, 2-(4-phenylthiophenyl)-4,6-bis-(trichloromethyl)-1,3,5-triazine, 2-(4-(4-methoxyphenyl)-thiophenyl)-4,6-bis(trichloromethyl)-1,3,5-triazine, 2-(4-tertbutylthiophenyl)-4,6-bis(trichloromethyl)-1,3,5-triazine and 2-(4-methylthiophenyl)-4,6-bis-(tribromomethyl)-1,3,5-triazine. A mixture of two or more triazines may be employed if required.

The component (a) of the present invention is provided by one or more ethylenically unsaturated polymerisable compounds including resins and acrylates such as acrylate or methacrylate monomers with di- or poly-functionality or functionalised acrylate or methacrylate polymers. Component (b) may for example be provided by polyester acrylate or dipentaerythritol pentaacrylate.

The component (c) of the present invention is provided by at least one compound absorbing in the region 400-600nm selected from

(i) dyes other than azo dyes, for example fluorescein, thioflavine T, acridine orange, eosin Y lactone, and cyanine dyes;

(ii) ketocoumarins, for example 3,3′-carbonylbis-(7-diethylaminocoumarin) and 7-diethylamino-5′,7′-dimethoxy-3,3′-carbonylbis(coumarin); the ketocoumarins described in US 4289844, GB 1878662 and EP 0022188 which absorb in the appropriate region may be employed in the present invention;

(iii) compounds of formula II, for example 2-(4-dimethylaminobenzylidene)indan-1,3-dione and 2-(2,4,6-trimethoxybenzylidene) indan-1,3-dione; and

(iv) pyrylium salts and thiapyrylium salts having a cation of formula III; suitable anions include $BF_4^-$, $PF_5^-$, $C1O_4^-$; examples of such salts are 2,6-diphenyl-4-(4-butoxyphenyl) thiapyrylium tetrafluoroborate and 2,6-bis(4-methoxyphenyl)-4-(4-butoxyphenyl)pyrylium tetrafluoroborate. The compounds having cations of formula III described in US 4474868 which absorb in the appropriate region may be employed in the present invention.

Preferably a binder will be included in the composition to improve its solidity and to reduce stickiness. The binder will normally be provided by a compound which does not take part in the polymerisation reaction but which provides bulk to the composition, for example cellulose acetate butyrate. If desired a surfactant may also be included in the composition. The component (c) of the present invention will normally be coloured because of its absorption in the range 400-600nm. However, additional coloured material may also be included in the composition of the present invention if desired.

Preferably, the component (b) will be present in an amount of 0.5 to 20% by weight of the composition more preferably 1 to 15 weight %. The component (c) will also preferably be present in an amount of 0.5 to 20% by weight of the composition, preferably 1 to 15 weight %. The total of component (a) and binder present will preferably be in the range 60 to 99% by weight, more preferably 70 to 98% by weight. Advantageously the composition will comprise 25 to 35 weight % binder and 35 to 64 weight % component (a).

The present invention also provides a method of forming a photosensitive printing plate comprising (a) dissolving a photosensitive composition as described above in an organic solvent, such as oxitol or dimethylformamide, to form a solution, (b) applying the solution of (a) to a substrate and then drying to form a layer of photosensitive composition on the substrate, and optionally (c) applying a protective coating, for example a polyvinylalcohol coating, over the layer.

The protective coating provides protection from atmospheric oxygen and thereby reduces the likelihood of inhibition of the polymerisation reaction by that oxygen. A surfactant is also preferably included in the coating.

Printing plates formed according to the invention may be exposed in a conventional manner for example with a print-down frame using a silver photomask, or with a scanning focussed beam such as that from an argon-ion laser.

The present invention will now be further described with reference to the following Examples.

<u>Example 1</u>

A solution of photopolymerisable composition was formed by dissolving the following compounds in oxitol. The amounts are given in weight %.

| | | |
|---|---|---|
| Component (a) | Ebecryl 810 (polyester acrylate, UCB Chemicals)<br>Sartomer SR-399 (dipentaerythritol pentaacrylate, Arco Speciality Chemicals) | 35%<br>25% |
| Component (b)<br>Component (c)<br>Binder | 2-(4-Methylthiophenyl)-4,6-bis (trichloromethyl)-1,3,5-triazine<br>3,3′-Carbonylbis(7-diethylaminocoumarin)<br>Cellit BP900 (cellulose acetate butyrate, Bayer AG) | 1%<br>1%<br>38% |

The solution was then applied to an anodised aluminium sheet and dried to leave a layer of photopolymerisable composition about 1μm thick on the sheet. A protective coating comprising 83 weight % Gohsenol KH17 (polyvinylalcohol) and 17 weight % Ethylan CPG660 (surfactant, Lankro) was then applied over the layer to protect it from inhibition by atmospheric oxygen.

The relative sensitivity to 488 mm light of the photosensitive printing plate so produced was then measured using a focussed argon ion laser and an appropriate light meter.

The results are shown in Table I.

Examples 2 to 4

The procedure of Example 1 was repeated but in each case component (b) and/or (c) was altered as indicated .in Table I. The results are shown in Table I as relative sensitivities in which a higher number indicates a greater sensitivity.

Comparative Examples 1 and 2

The procedure of Example 1 was again followed but in this case no component (b) was employed and the amount of binder employed was increased to 39 wt%. The component (c) employed in each comparative example is indicated in Table I together with the results which are expressed in the same way as for Examples 1 to 4.

Examples 5 to 29

The procedure of Example 1 was repeated but in each case component (b) and/or (c) was altered as indicated in Tables 2a to 2e.

In these examples sensitivity is given in absolute units of $mJcm^{-2}$, rather than as relative sensitivities, and a lower number indicates a greater sensitivity.

Comparative Examples 3 to 7

The procedure of Example 1 was repeated but the amount of binder employed was increased to 39 wt% and component (b) was omitted. The component (c) employed in each case is indicated in Tables 2a to 2e together with the results which are expressed in the same way as for Examples 5 to 29.

TABLE I

| Example No. | Component (b) | Component (c) | Relative Sensitivity + |
|---|---|---|---|
| 1 | 2-(4-methylthiophenyl)-4,6-bis (trichloromethyl)-1,3,5-triazine | 3-3'-carbonylbis(7-diethylaminocoumarin) | 18 |
| 2 | " " | 7-diethylamino-5',7'-dimethoxy-3,3'-carbonylbis(coumarin) | 0.65 |
| 3 | 2-(4-methylthiophenyl)-4,6-bis (tribromomethyl)-1,3,5-triazine | 2,6-diphenyl-4-(4-butoxyphenyl)thiapyrylium tetrafluoroborate | 0.38 |
| 4 | " " | 2-(4-dimethylaminobenzylidene) indan-1,3-dione | 1.0 |
| Comp.1 | none | 3,3'-carbonylbis(7-diethylamino coumarin) | 0.22 |
| Comp.2 | none | 2,6-diphenyl-4(4-butoxyphenyl) thiapyrylium tetrafluoroborate | 0.027 |

+ Higher number indicates greater sensitivity

Table 2a

Component (c):
3,3'-carbonylbis(7-diethylaminocoumarin)

| Example No. | Component (b) | Sensitivity (mJ $cm^{-2}$)* |
|---|---|---|
| Comp. 3 | - | 190 |
| 5 | 2-(4-methylthiophenyl)-4,6-bis (trichloromethyl)-1,3,5-triazine | 2.3 |
| 6 | 2-(4-methylthiophenyl)-4,6-bis (tribromomethyl)-1,3,5-triazine | 7.4 |
| 7 | 2-(4-tertbutylthiophenyl)-4,6-bis (trichloromethyl)-1,3,5-triazine | 4.0 |
| 8 | 2-(4-stearylthiophenyl)-4,6-bis (trichloromethyl)-1,3,5-triazine | 6.1 |
| 9 | 2-(4-ethylthiophenyl)-4,6-bis (trichloromethyl)-1,3,5-triazine | 2.5 |
| 10 | 2-(4-phenylthiophenyl)-4,6-bis (trichloromethyl)-1,3,5-triazine | 3.6 |

* lower number indicates greater sensitivity

Table 2b

Component (c):
7-diethylamino-5',7'-dimethoxy-3,3'-carbonylbis(coumarin)

| Example No. | Component (b) | Sensitivity (mJ $cm^{-2}$)* |
|---|---|---|
| Comp. 4 | - | >1000 |
| 11 | 2-(4-methylthiophenyl)-4,6-bis (trichloromethyl)-1,3,5-triazine | 65 |
| 12 | 2-(4-methylthiophenyl)-4,6-bis (tribromomethyl)-1,3,5-triazine | 69.7 |
| 13 | 2-(4-tertbutylthiophenyl)-4,6-bis (trichloromethyl)-1,3,5-triazine | 217 |
| 14 | 2-(4-ethylthiophenyl)-4,6-bis (trichloromethyl)-1,3,5-triazine | 67 |
| 15 | 2-(4-stearylthiophenyl)-4,6-bis (trichloromethyl)-1,3,5-triazine | 163 |

Table 2c

Component (c):
2,6-bisphenyl-4-(4-butoxyphenyl)thiapyrylium tetrafluoroborate

| Example No. | Component (b) | Sensitivity (mJ $cm^{-2}$)* |
|---|---|---|
| Comp. 5 | - | >1000 |
| 16 | 2-(4-methylthiophenyl)-4,6-bis (trichloromethyl)-1,3,5-triazine | 167 |
| 17 | 2-(4-methylthiophenyl)-4,6-bis (tribromomethyl)-1,3,5-triazine | 110 |

*lower number indicates greater sensitivity

Table 2d

Component (c):
2,6-bis(4-methoxyphenyl)-4-(4-butoxyphenyl)pyrylium tetrafluoroborate as sensitiser

| Example No. | Component (b) | Sensitivity (mJ $cm^{-2}$)* |
|---|---|---|
| Comp. 6 | - | >1000 |
| 18 | 2-(4-methylthiophenyl)-4,6-bis (trichloromethyl)-1,3,5-triazine | 300 |
| 19 | 2-(4-methylthiophenyl)-4,6-bis (tribromomethyl)-1,3,5-triazine | 300 |
| 20 | 2-(4-phenylthiophenyl)-4,6-bis (trichloromethyl)-1,3,5-triazine | 390 |
| 21 | 2-(4-ethylthiophenyl)-4,6-bis (trichloromethyl)-1,3,5-triazine | 325 |
| 22 | 2-(4-tertbutylthiophenyl)-4,6-bis (trichloromethyl)-1,3,5-triazine | 390 |
| 23 | 2-(4-stearylthiophenyl)-4,6-bis (trichloromethyl)-1,3,5-triazine | 650 |

Table 2e

Component (c):
2-(4-dimethylaminobenzylidene)-indan-1,3-dione

| Example No. | Component (b) | Sensitivity (mJ $cm^{-2}$)* |
|---|---|---|
| Comp. 7 | - | >1000 |
| 24 | 2-(4-methylthiophenyl)-4,6-bis (trichloromethyl)-1,3,5-triazine | 80 |
| 25 | 2-(4-methylthiophenyl)-4,6-bis (tribromomethyl)-1,3,5-triazine | 96 |
| 26 | 2-(4-phenylthiophenyl)-4,6-bis (trichloromethyl)-1,3,5-triazine | 217 |
| 27 | 2-(4-ethylthiophenyl)-4,6-bis (trichloromethyl)-1,3,5-triazine | 163 |
| 28 | 2-(4-stearylthiophenyl)-4,6-bis (trichloromethyl)-1,3,5-triazine | 244 |
| 29 | 2-(4-tertbutylthiophenyl)-4,6-bis (trichloromethyl)-1,3,5-triazine | 229 |

*lower number indicates greater sensitivity

## Claims

1. A photopolymerisable composition characterised by comprising
   (a) one or more ethylenically unsaturated polymerisable compounds
   (b) at least one triazine compound of formula I

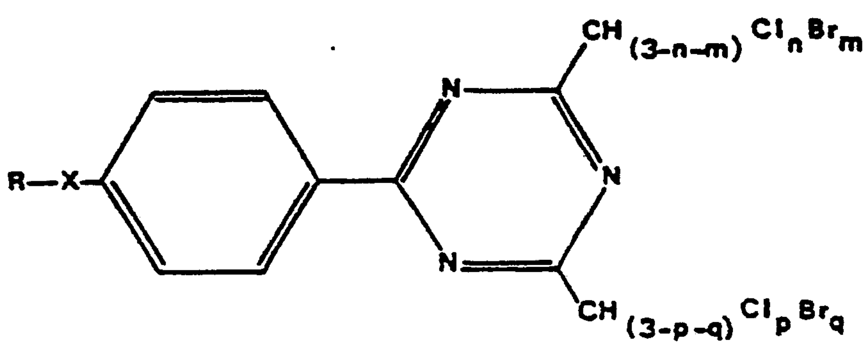

I

wherein n, m, p and q are each independently 0, 1, 2 or 3, the sum of n+m is not greater than 3, the sum of p+q is not greater than 3 and the sum of n+m+p+q is at least one, X is a sulphur, selenium or tellurium atom and R is an alkyl group or an aryl group,

(c) at least one compound absorbing in the region 400-600nm selected from
(i) dyes, other than azo dyes,
(ii) ketocoumarins,
(iii) 2-benzylideneindan-1,3-diones of formula II

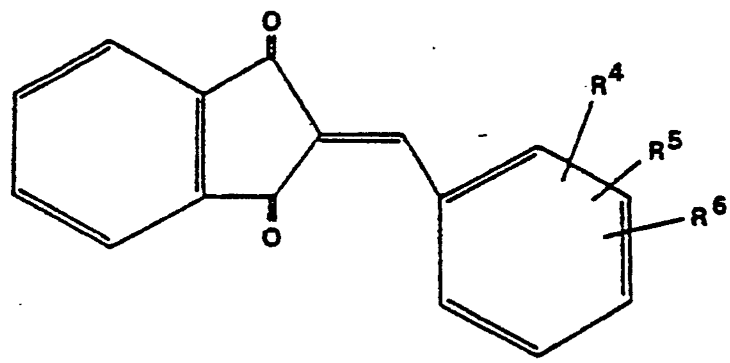

II

wherein $R^4$, $R^5$ and $R^6$ are each independently each a hydrogen atom, an alkoxy group, a dialkylamino group or an alkyl group,
and
(iv) pyrylium salts and thiapyrylium salts having a cation of formula III

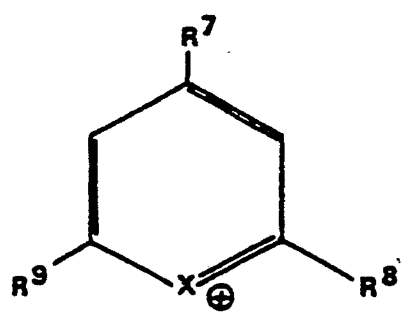

III

wherein X is oxygen or sulphur and $R^7$, $R^8$ and $R^9$ are each independently an aryl group.

2. A composition as claimed in claim 1 characterized in that component (a) comprises one or more polymerisable acrylates.

3. A composition as claimed in claim 1 or claim 2 characterized in that component (b) comprises at least one triazine selected from 2-(4-methylthiophenyl)-4,6-bis(trichloromethyl)-1,3,5-triazine, 2-(4-ethylthiophenyl)-4,6-bis-(trichloromethyl)-1,3,5-triazine, 2-(4-stearylthiophenyl)-4,6-bis(trichloromethyl)-1,3,5-triazine, 2-(4-phenylthiophenyl)-4,6-bis(trichloromethyl)-1,3,5-triazine, 2-(4-(4-methoxyphenyl)-thiophenyl)-4,6-bis(trichloromethyl)-1,3,5-triazine, 2-(4-tertbutylthiophenyl)-4,6-bis(trichloromethyl)-1,3,5-triazine and 2-(4-methylthiophenyl)-4,6-bis(tribromomethyl)-1,3,5-triazine.

4. A composition as claimed in any one of claims 1 to 3 characterized in that component (c) comprises at least one dye selected from fluorescein, thioflavine T, acridine orange, eosin Y lactone, and cyanine dyes.

5. A composition as claimed in any one of claims 1 to 4 characterized in that component (c) comprises at least one ketocoumarin selected from 3,3′-carbonylbis- (7-diethylaminocoumarin) and 7-diethylamino-5′,7′-dimethoxy-3,3′-carbonylbis-(coumarin).

6. A composition as claimed in any one of claims 1 to 5 characterized in that component (c) comprises at least one compound of formula II selected from 2-(4-dimethylaminobenzylidene)indane-1,3-dione and 2-(2,4,6-trimethoxybenzylidene) indan-1,3-dione.

7. A composition as claimed in any one of claims 1 to 6 characterized in that component (c) comprises at least one salt selected from 2, 6-diphenyl-4-(4-butoxyphenyl)thiapyrylium tetrafluoroborate and 2,6-bis(4-methoxyphenyl)-4-(4-butoxyphenyl)pyrylium tetrafluoroborate.

8. A composition as claimed in any one of claims 1 to 7 characterized by comprising 0.5 to 20% by weight component (b).

9. A composition as claimed in any one of claims 1 to 8 characterized by comprising 0.5 to 20% by weight component (c).

10. A composition as claimed in any one of claims 1 to 9 characterized in that 60 to 99% by weight is provided by the total of component (a) and binder.

11. A composition as claimed in claim 10 characterized by comprising 25 to 35 % by weight binder and 35 to 64 % by weight component (a).

12. A composition as claimed in any one of claims 1 to 11 characterized in that component (b) comprises at least one triazine compound of formula I in which the sum of $n+m$ and the sum of $p+q$ are each 3.

13. A method of forming a photosensitive printing plate comprising (a) dissolving a photosensitive composition as claimed in any one of claims 1 to 12 in an organic solvent to form a solution, (b) applying the solution of (a) to a substrate and then drying to form a layer of photosensitive composition on the substrate, and optionally (c) applying a protective coating over the layer.

14. A photosensitive printing plate comprising a photosensitive composition as claimed in any one of claims 1 to 12.